# EUROPEAN PATENT APPLICATION

(11) **EP 3 076 759 A1**
(43) Date of publication of application: **05.10.2016**
(21) Application number: 16171124.7
(22) Date of filing: 22.03.2000
(51) Int. Cl.: H05B 33/12, C09K 11/06, H01L 51/00, H01L 51/50

(54) **CYCLOMETALLATED METAL COMPLEXES AS PHOSPHORESCENT DOPANTS IN ORGANIC LEDS**

(30) Priority: 23.03.1999 US 274609
(62) Divisional of application: 00918238.7
(71) Applicant: THE UNIVERSITY OF SOUTHERN CALIFORNIA, Los Angeles, California 90089 (US)
(72) Inventor: LAMANSKY, Sergey, Ewing, NJ 08618 (US); THOMPSON, Mark E., Ewing, NJ 08618 (US)
(74) Representative: Maiwald Patentanwalts GmbH

(57) **Abstract**

The use of a phosphorescent organometallic platinum complex as an emissive molecule in an organic light emitting device comprising a heterostructure for producing luminescence when a voltage is applied across the heterostructure.

## Description

### FIELD OF INVENTION

The present invention is directed to organic light emitting devices (OLEDs) comprised of emissive layers that contain an organometallic phosphorescent dopant compound.

### BACKGROUND OF THE INVENTION

Organic light emitting devices (OLEDs) are comprised of several organic layers in which one of the layers is comprised of an organic material that can be made to electroluminesce by applying a voltage across the device, C.W. Tang et al., Appl. Phys. Lett. 1987, 51, 913. Certain OLEDs have been shown to have sufficient brightness, range of color and operating lifetimes for use as a practical alternative technology to LCD-based full color flat-panel displays (S.R. Forrest, P.E. Burrows and M.E. Thompson, Laser Focus World, Feb. 1995). Since many of the thin organic films used in such devices are transparent in the visible spectral region, they allow for the realization of a completely new type of display pixel in which red (R), green (G), and blue (B) emitting OLEDs are placed in a vertically stacked geometry to provide a simple fabrication process, a small R-G-B pixel size, and a large fill factor, International Patent Application No. PCT/US95/15790.

A transparent OLED (TOLED), which represents a significant step toward realizing high resolution, independently addressable stacked R-G-B pixels, was reported in International Patent Application No. PCT/US97/02681 in which the TOLED had greater than 71% transparency when turned off and emitted light from both top and bottom device surfaces with high efficiency (approaching 1% quantum efficiency) when the device was turned on. The TOLED used transparent indium tin oxide (ITO) as the hole-injecting electrode and a Mg-Ag-ITO electrode layer for electron-injection. A device was disclosed in which the ITO side of the Mg-Ag-ITO electrode layer was used as a hole-injecting contact for a second, different color-emitting OLED stacked on top of the TOLED. Each layer in the stacked OLED (SOLED) was independently addressable and emitted its own characteristic color. This colored emission could be transmitted through the adjacently stacked, transparent, independently addressable, organic layer or layers, the transparent contacts and the glass substrate, thus allowing the device to emit any color that could be produced by varying the relative output of the red and blue color-emitting layers.

The PCT/US95/15790 application disclosed an integrated SOLED for which both intensity and color could be independently varied and controlled with external power supplies in a color tunable display device. The PCT/US95/15790 application, thus, illustrates a principle for achieving integrated, full color pixels that provide high image resolution, which is made possible by the compact pixel size. Furthermore, relatively low cost fabrication techniques, as compared with prior art methods, may be utilized for making such devices.

Such devices whose structure is based upon the use of layers of organic optoelectronic materials generally rely on a common mechanism leading to optical emission. Typically, this mechanism is based upon the radiative recombination of a trapped charge. Specifically, OLEDs are comprised of at least two thin organic layers separating the anode and cathode of the device. The material of one of these layers is specifically chosen based on the material's ability to transport holes, a "hole transporting layer" (HTL), and the material of the other layer is specifically selected according to its ability to transport electrons, an "electron transporting layer" (ETL). With such a construction, the device can be viewed as a diode with a forward bias when the potential applied to the anode is higher than the potential applied to the cathode. Under these bias conditions, the anode injects holes (positive charge carriers) into the hole transporting layer, while the cathode injects electrons into the electron transporting layer. The portion of the luminescent medium adjacent to the anode thus forms a hole injecting and transporting zone while the portion of the luminescent medium adjacent to the cathode forms an electron injecting and transporting zone. The injected holes and electrons each migrate toward the oppositely charged electrode. When an electron and hole localize on the same molecule, a Frenkel exciton is formed. Recombination of this short-lived state may be visualized as an electron dropping from its conduction potential to a valence band, with relaxation occurring, under certain conditions, preferentially via a photoemissive mechanism. Under this view of the mechanism of operation of typical thin-layer organic devices, the electroluminescent layer comprises a luminescence zone receiving mobile charge carriers (electrons and holes) from each electrode.

The materials that produce the electroluminescent emission are frequently the same materials that function either as the electron transporting layer or as the hole transporting layer. Such devices in which the electron transporting layer or the hole transporting layer also functions as the emissive layer are referred to as having a single heterostructure. Alternatively, the electroluminescent material may be present in a separate emissive layer between the hole transporting layer and the electron transporting layer in what is referred to as a double heterostructure.

In addition to emissive materials that are present as the predominant component in the charge carrier layer, that is, either in the hole transporting layer or in the electron transporting layer, and that function both as the charge carrier material as well as the emissive material, the emissive material may be present in relatively low concentrations as a dopant in the charge carrier layer. Whenever a dopant is present, the predominant material in the charge carrier layer may be referred to as a host compound or as a receiving compound. Materials that are present as host and dopant are selected so as to have a high level of energy transfer from the host to the dopant material. In addition, these materials need to be capable of producing acceptable electrical properties for the OLED. Furthermore, such host and dopant materials are preferably capable of being incorporated into the OLED using starting materials that can be readily incorporated into the OLED by using convenient fabrication techniques, in particular, by using vacuum-deposition techniques.

It is desirable for OLEDs to be fabricated using materials that provide electroluminescent emission in a relatively narrow band centered near selected spectral regions, which correspond to one of the three primary colors, red, green and blue so that they may be used as a colored layer in an OLED or SOLED. It is also desirable that such compounds be capable of being readily deposited as a thin layer using vacuum deposition techniques so that they may be readily incorporated into an OLED that is prepared entirely from vacuum-deposited organic materials.

Co-pending U.S. 08/774,333, filed December 23, 1996, is directed to OLEDs containing emitting compounds that produce a saturated red emission.

### SUMMARY OF THE INVENTION

The present invention is directed to organic light emitting devices wherein the emissive layer comprises a host material, an emissive molecule present as a dopant in said host material, which molecule is adapted to luminesce when a voltage is applied across the heterostructure, wherein the emissive molecule is selected from the group of phosphorescent organometallic complexes. The emissive molecule may be further selected from the group of phosphorescent organometallic platinum complexes and may be still further selected from the group of phosphorescent cyclometallated platinum complexes. The host material may be a hole-transporting matrix selected from the group of substituted tri-aryl amines. The host material may be an electron-transporting matrix selected from the group of metal quinoxolates, oxidazoles and triazoles.

The present invention covers articles of manufacture comprising OLEDs comprising a new family of phosphorescent materials, to be used as dopants in OLEDs, and methods of manufacturing the articles. These phosphorescent materials are cyclometallated platinum complexes, which provide electroluminiscent emission at a wavelength between 400 nm and 700 nm. The present invention is further directed to OLEDs that are capable of producing an emission which will appear blue, that will appear green, and that will appear red.

More specifically, OLEDs of the present invention comprise an emissive layer comprised of platinum (II) complexed with Bis[2-(2-phenyl)pyridinato-N,C2], Bis[2-(2'-thienyl)pyridinato-N,C3], and Bis[benzo(h)quinolinato-N,C]. The compound cis-Bis[2-(2'-thienyl)pyridinato-N,C3] Pt(II) gives a strong orange to yellow emission.

The invention is further directed to emissive layers wherein the emissive molecule is selected from the group of phosphorescent organometallic complexes, wherein the emissive molecule contains substituents selected from the class of electronic donors and electronic acceptors. The emissive molecule may be further selected from the group of phosphorescent organometallic platinum complexes and may be still further selected from the group of phosphorescent cyclometallated platinum complexes, wherein the organic molecule contains substituents selected from the class of electronic donors and electronic acceptors.

The invention is further directed to an organic light emitting device comprising a heterostructure for producing luminescence, wherein the emissive layer comprises a host material, an emissive molecule, present as a dopant in said host material, adapted to luminesce when a voltage is applied across the heterostructure, wherein the emissive molecule is selected from the group consisting of cyclometallated platinum complexes and wherein there is a polarization molecule, present as a dopant in the host material, which polarization molecule has a dipole moment and which polarization molecule alters the wavelength of the luminescent light emitted by the emissive dopant molecule. The polarization molecule may be an aromatic molecule substituted by electronic donors and electronic acceptors.

The present invention is directed to OLEDs, and a method of fabricating OLEDs, in which emission from the device is obtained via a phosphorescent decay process wherein the phosphorescent decay rate is rapid enough to meet the requirements of a display device. More specifically, the present invention is directed to OLEDs comprised of a material that is capable of receiving the energy from an exciton singlet or triplet state and emitting that energy as phosphorescent radiation.

The OLED of the present invention may be used in substantially any type of device which is comprised of an OLED, for example, in OLEDs that are incorporated into a larger display, a vehicle, a computer, a television, a printer, a large area wall, theater or stadium screen, a billboard or a sign.

### BRIEF DESCRIPTION OF THE DRAWINGS

Figure 1. Electronic absorbance spectra of Pt(thpy)₂, Pt(thq)₂, and Pt(bph)(bpy).
Figure 2. Emission spectra of Pt(thpy)₂, Pt(thq)₂, and Pt(bph)(bpy).
Figure 3. Energy transfer from polyvinylcarbazole (PVK) to Pt(thpy)₁ in the solid film.
Figure 4. Characteristics of OLED with Pt(thpy)₂ dopant: (a) I-V characteristic (b) Light output curve.
Figure 5. Quantum efficiency dependence on applied voltage for OLED with Pt(thpy)₂ dopant.
Figure 6. Characteristics of the OLED device with Pt(thpy)₂ dopant: (a) normalized electroluminescence (EL) spectrum of the device at 22 V (b) CIE diagram based on normalized EL spectrum.

### DETAILED DESCRIPTION OF THE INVENTION

The present invention is generally directed to emissive molecules, which luminesce when a voltage is applied across a heterostructure of an organic light-emitting device and which molecules are selected from the group of phosphorescent organometallic complexes. The term "organometallic" is as generally understood by one of ordinary skill, as given, for example, in "Inorganic Chemistry" (2nd edition) by Gary L. Miessler and Donald A. Tarr, Prentice-Hall (1998). The invention is further directed to emissive molecules within the emissive layer of an organic light-emitting device which molecules are comprised of phosphorescent cyclometallated platinum complexes. On electroluminescence, molecules in this class may produce emission which appears red, blue, or green. Discussions of the appearance of color, including descriptions of CIE charts, may be found in H. Zollinger, Color Chemistry, VCH Publishers, 1991 and H. J. A. Dartnall, J. K. Bowmaker. and J. D. Mollon, Proc. Roy. Soc. B (London). 1983, 220, 115-130.

The present invention will now be described in detail for specific preferred embodiments of the invention, it being understood that these embodiments are intended only as illustrative examples and the invention is not to be limited thereto.

### Synthesis of the cyclometallated platinum complexes

We have synthesized a number of different Pt cyclometalated complexes.

Numerous publications, reviews and books are dedicated to the chemistry of cyclometalated compounds, which also are called intramolecular-coordination compounds. (I.Omae, Organometallic Intramolecular-coordination compounds. N.Y. 1986. G.R.Newkorne, W.E.Puckett, V.K.Gupta, G.E.Kiefer, Chem.Rev. 1986.86,451. A.D.Ryabov, Chem.Rev. 1990, 90, 403.) Most of the publications depict mechanistical aspects of the subject and primarily on the cyclometalated compounds with one bi- or tri-dentate ligand bonded to metal by C-M single bond and having cycle closed with one or two other X-M bonds where X may be N, S, P, As, O. Not so much literature was devoted to bis- or tris-cyclometalated complexes, which do not possess any other ligands but C,N type bi-dentate ones. The subject of this invention is in these compounds because they are not only expected to have interesting photochemical properties as most cyclometalated complexes do, but also should exhibit increased stability in comparison with their monocyclometalated analogues. Most of the work on bis-cyclopaladated and bis-cycloplatinated compounds was performed by von Zelewsky *et al.* (For a review see: M.Maestri, V.Balzani, Ch.Deuschel-Cornioley, A.von Zelewsky, Adv.Photochem.1992 17, 1. L.Chassot, A.Von Zelewsky, Helv. Chim.Acta 1983, 66, 243. L.Chassot, E.Muler, A. von Zelewsky, Inorg. Chem. 1984, 23, 4249. S Bonafede, M.Ciano, F.Boletta. V.Balzani, L.Chassot, A. von Zelewsky, J.Phys.Chem. 1986, 90, 3836. L.Chassot, A.von Zelewsky, D.Sandrini, M.Maestri, V.Balzani, J.Am.Chem.Soc. 1986, 108, 6084. Ch.Cornioley-Deuschel, A.von Zelewsky, Inorg. Chem. 1987, 26, 3354. L.Chassot, A.von Zelewsky, Inorg. Chem. 1987, 26, 2814. A.von Zelewsky, A.P. Suckling, H.Stoeckii-Evans, Inorg. Chem. 1993, 32, 4585. A. von Zelewsky, P.Belser, P.Hayoz, R.Dux, X.Hua, A.Suckling. H.Stoeckii-Evans, Coord. Chem.Rev. 1994, 132, 75. P.Jolliet, M.Gianini, A.von Zelewsky, G.Bernardinelli, H.Stoeckii-Evans, Inorg. Chem. 1996, 35, 4883. H.Wiedenhofer, S.Schutzenmeier, A.von Zelewsky, H.Yersin, J.Phys. Chem. 1995, 99, 13385 . M. Gianini, A.von Zelewsky, H. Stoeckii-Evans, Inorg. Chem. 1997, 36, 6094.) In one of their early works, (M.Maestri, D.Sandrini, V.Balzani, L.Chassot, P.Jolliet, A.von Zelewsky, Chem.Phys.Lett. 1985,122,375) luminescent properties of three bis-cycloplatinated complexes were investigated in detail. The summary of the previously reported results on Pt bis-cyclometalated complexes important for our current research is as follows:
i. in general, cyclometalated complexes having 5-membered ring formed between the metal atom and C,X ligand are more stable.
ii. from the point of view of stability of resulting compounds, complexes not containing anionic ligands are preferred; thus, bis-cyclometalated complexes are preferred to mono-cyclometalated ones.
iii. a variety of Pt(Pd) cyclometalated complexes were synthesized, homoleptic (containing similar C,X ligands), heteroleptic (containing two different cyclometalating C,X ligands) and complexes with one C,C cyclometalating ligand and one N,N coordinating ligand.
iv. most bis-cyclometalated complexes show M⁺ ions upon electron impact ionization in their mass spectra, this can be a base for our assumption on their stability upon vacuum deposition.
v. on the other hand, some of the complexes are found not to be stable in certain solvents; they undergo oxidative addition reactions leading to Pt(IV) or Pd(IV) octahedral complexes.
vi. optical properties are reported only for some of the complexes; mostly absorption data is presented. Low-energy electron transitions observed in their both absorption and emission spectra are assigned to MLCT transitions.
vii. reported luminescent properties are summarized in Table 1. Used abbreviations are explained in Scheme 1. Upon transition from bis-cyclometalated complexes with two C,N ligands to the complexes with one C,C and one N,N ligands batochromic shift in emission was observed. (M.Maestri, D.Sandrini, V.Balzani, A.von Zelewsky, C.Deuschel-Cornioley, P.Jolliet, Helv. Chim.Acta 1988, 71, 1053*.*

Table 1. Absorption and emission properties of several cycloplatinated complexes. Reproduced from A.von Zelewsky et. al (Chem. Phys. Lett., 1985, 122, 375 and Helv. Chim. Acta 1988, 17, 1053). Abbreviation explanations are given in Scheme 1

| | solvent | absorption | emission spectra | |
|---|---|---|---|---|
| | | λmax(ε) | 77K | 293K |
| | | | λmax(τ) | λmax(τ) |
| Pt(Phpy)₂**(1)** | CH₃CN | 402(12800) | 491(4.0) | - |
| | | 291(27700) | | |
| Pt(Thpy)₂**(2)** | CH₃CN | 418(10500) | 570(12.0) | 578(2.2) |
| | | 303(26100) | | |
| Pt(Bhq)₂**(3)** | CH₃CN | 421(9200) | 492(6.5) | - |
| | | 367(12500) | | |
| | | 307(15000) | | |
| Pt(bph)(bpy)**(4)** | | | | |

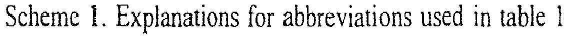

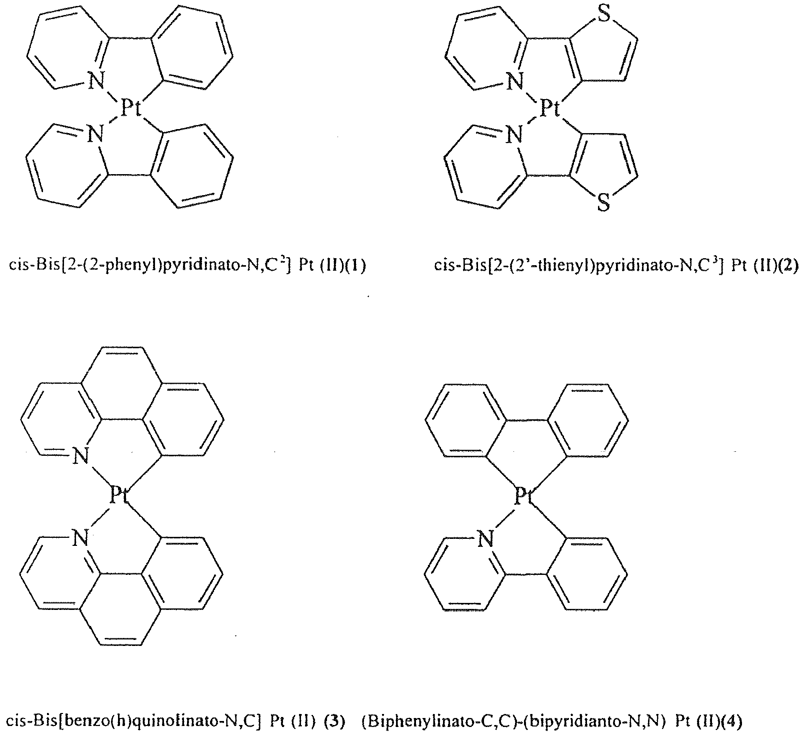

We synthesized different bis-cycloplatinated complexes in order to investigate their optical properties in different hosts, both polymeric and molecular, and utilize them as dopants in corresponding hosts for organic light-emitting diodes (OLEDs). Usage of the complexes in molecular hosts in OLEDs prepared in the vacuum deposition process requires several conditions to be satisfied. The complexes should be sublimable and stable at the standard deposition conditions (vacuum ∼10⁻⁶ torr). They should show emission properties interesting for OLED applications and be able to accept energy from host materials used, such as Alq₃ or NPD. On the other hand, in order to be useful in OLEDs prepared by wet techniques, the complexes should form true solutions in conventional solvents (e.g. CHCl₃) with a wide range of concentrations and exhibit both emission and efficient energy transfer from polymeric hosts *(e.g.* PVK). All these properties of cycloplatinated complexes were tested. In polymeric hosts we observe efficient luminescence from some of the materials.

### 2. Experimental section

*2-(2-thienyl)pyridine.* Synthesis is shown in Scheme 2, and was performed according to procedure close to the published one (T.Kauffmann, A.Mitschker, A.Woltermann, Chem.Ber. 1983, 116, 992. For purification of the product, instead of recommended distillation, zonal sublimation was used (145-145-125°C, 2-3 hours). Light brownish white solid (yield 69%). Mass-spec: m/z: 237(18%), 161 (100%. M⁻), 91 (71%). ¹H NMR (250 MHZ, DMSO-d₆) δ,ppm: 6.22-6.28 (d. of d., 1H), 6.70-6.80 (d. of d., 1H), 6.86-7.03 (m,3H), 7.60-7.65 (m,1H). ¹³C NMR (250 MHZ, DMSO-d₆): 118.6, 122.3, 125.2, 128.3, 128.4, 137.1, 144.6, 149.4, 151.9.

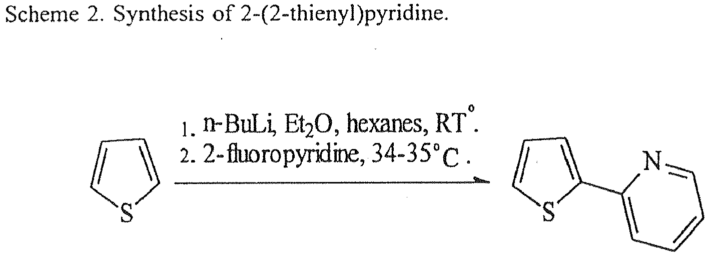

*2-(2-thienyl)quinoline.* Synthesis is displayed in Scheme 3, and was made according to published procedure (K.E. Chippendale, B.Iddon, H.Suschitzky, J. Chem. Soc. 1949, 90, 1871). Purification was made exactly following the literature as neither sublimation nor column chromatography did not give as good results as recrystallizations from a. petroleum ether, and b. EtOH-H₂O (1:1) mixture Pale yellow solid, gets more yellow with time (yield 84%). Mass-spec: m/z: 217 (32%), 216 (77%), 215 (83%), 214 (78%), 213 (77%), 212 (79%), 211(100%, M⁺), 210 (93%), 209 (46%). ¹H NMR (250 MHZ, DMSO-d₆) δ,ppm: 7.18-7.24 (d. of d.,1H), 7.48-7.58 (d. of d. of d.,1H), 7.67-7.78 (m,2H), 7.91-7.97 (m,3H), 8.08-8.11 (d,1H), 8.36-8.39 (d,1H).

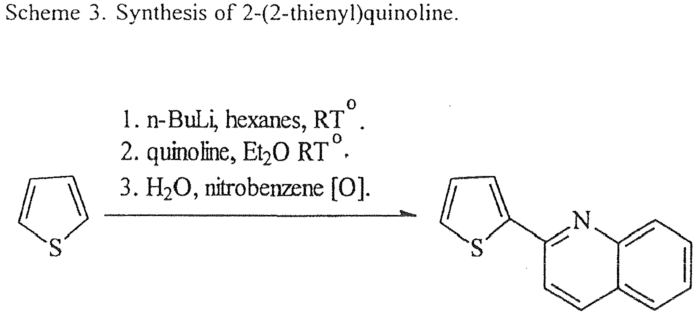

*2-(2'-bromophenyl)pyridine.* Synthesis was performed according to literature (D.H. Hey, C.J.M.Stirling, G.H.Williams, J.Chem. Soc. 1955, 3963. R.A.Abramovich, J.G.Saha, J.Chem.Soc. 1964, 2175. It is outlined in Scheme 4. Literature on the subject was dedicated to the study of aromatic substitution in different systems, including pyridine, and study of isomeric ratios in the resulting product. Thus in order to resolve isomer mixtures of different substituted phenylpyridines, not 2-(2'-bromophenyl)pyridine, the authors utilized 8ft.x¼ in. column packed with ethylene glycol succinate (10%) on Chromosorb W at 155°C and some certain helium inlet pressure. For resolving the reaction mixture we obtained, we used column chromatography with hexanes:THF (1:1) and haxanes:THF:PrOH-1 (4:4:1) mixtures as eluents on silica gel because this solvent mixture gave best results in TLC (three well resolved spots). Only the first spot in the column gave mass spec major peak corresponding to n-(2'-bromophenyl)pyridines (m/z: 233, 235), in the remaining spots this peak was minor. Mass spec of the first fraction: m/z: 235 (97%), 233 (100%,M⁺), 154 (86%), 127 (74%). ¹H NMR of the first fraction (250 MHZ, DMSO-d6) δ, ppm: 7.27-7.51 (m,4H), 7.59-7.96 (m,2H), 8.57- 8.78 (m,2H).

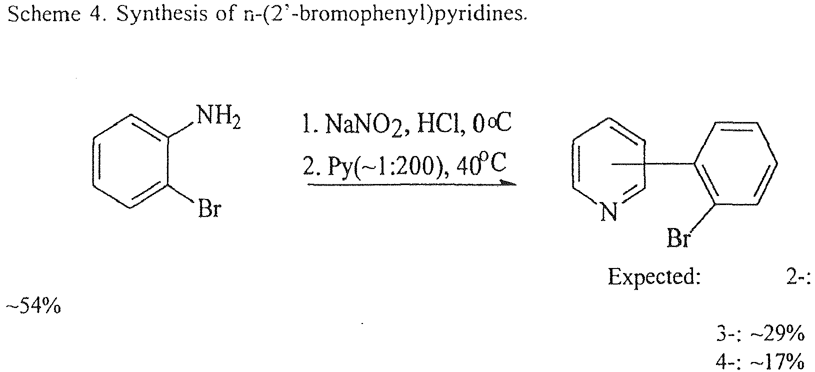

Sublimation of the 1^{st} fraction product after column did not lead to disappearance of the peaks of contaminants in ¹H NMR spectrum, and we do not expect the sublimation to lead to resolving the isomers if present.

*2-phenylpyridine.* Was synthesized by literature procedure (J.C.W. Evans, C.F.H. Allen, Org. Synth. Cell. 1943, 2, 517) and is displayed in Scheme 5. Pale yellow oil darkening in the air (yield 48%). ¹H NMR (250 MHZ, DMSO-d₆) of the product after vacuum distillation: δ,ppm: 6.70-6.76 (m,1H), 6.92-7.10 (m,3H), 7.27-7.30 (m,1H), 7.36-7.39 (q,1H), 7.60-7.68 (m,2H), 8.16-8.23 (m,1H)).

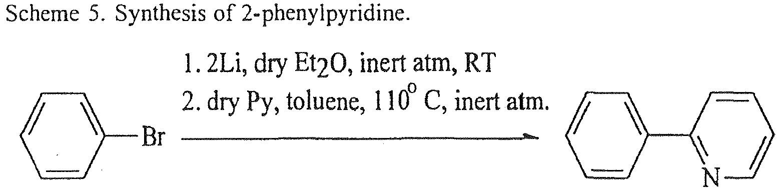

*2,2'-diaminobiphenyl.* Was prepared by literature method (R.E.Moore, A.Furst. J.Org. Chem. 1958, 23, 1504) (Scheme 6). Pale pink solid (yield 69%). ¹H NMR (250 MHZ, DMSO-d₆) δ,ppm: 5.72-5.80 (t. of d.,2H), 5.87-5.93 (d. of d., 2H), 6.03-6.09 (d. of d.,2H), 6.13-6.23 (t. of d.,2H). Mass spec: m/z: 185 (40%), 184 (100 %, M⁻), 183 (73%), 168 (69%), 167 (87%), 166(62%), 139 (27%).

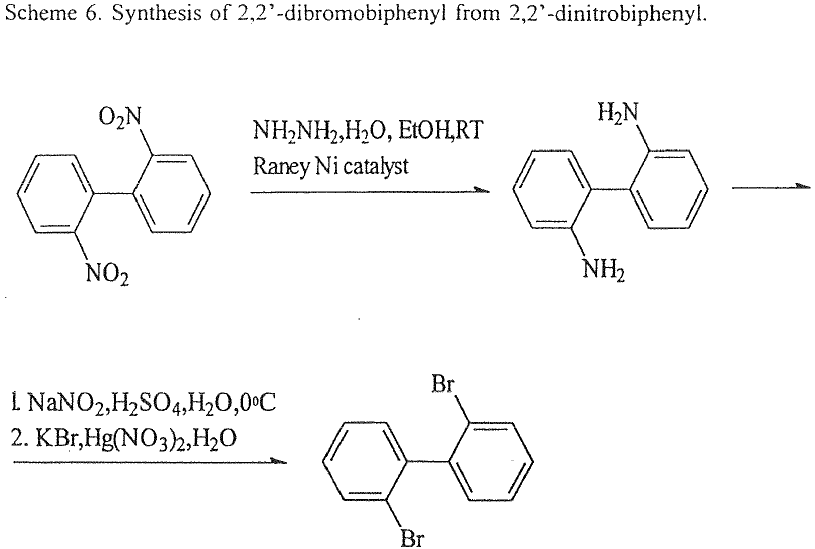

*2,2'-dibromobiphenyl.* (Scheme 6) (A. Uehara, J.C.Bailar, Jr., J.Organomet. Chem.1982, 239,1.)).

*2,2'-dibromo-,1,1'-binaphthyl.* Was synthesized according to literature (H.Takaya, S. Akutagawa, R.Noyori, Org.Synth. 1989, 67,20). (Scheme 7). 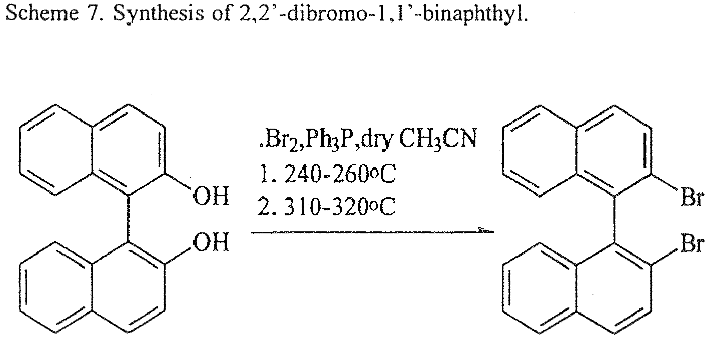 *trans-Dichloro-bis-(diethyl sulfide*) *platinum* (II). Prepared by a published procedure (G.B.Kauffman, D.O.Cowan. Inorg. Synth.1953, 6, 211). (Scheme 8). Bright yellow solid (yield 78%).

*cis-Dichloro-bis-(diethyl sulfide) platinum* (II).Prepared by a published procedure (G. B.Kauffman. D.O.Cowan, Inorg. Synth.1953, 6, 211). Yellow solid (63%). 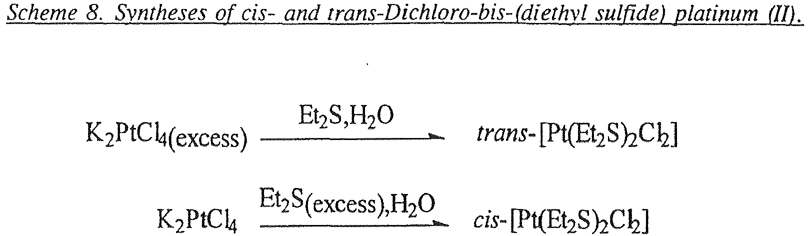 *cis-Bis[2-(2'-thienyl)pyridinato-N,C^{5'} platinum (II).* Was synthesized according to literature methods (L.Chassot, A.von Zelewsky, Inorg. Chem. 1993, 32, 4585). (Scheme 9). Bright red crystals (yield 39%). Mass spec: m/z: 518 (25%), 517 (20%), 516 (81%), 513 (100%,M⁺), 514 (87%), 481 (15%), 354 (23%). 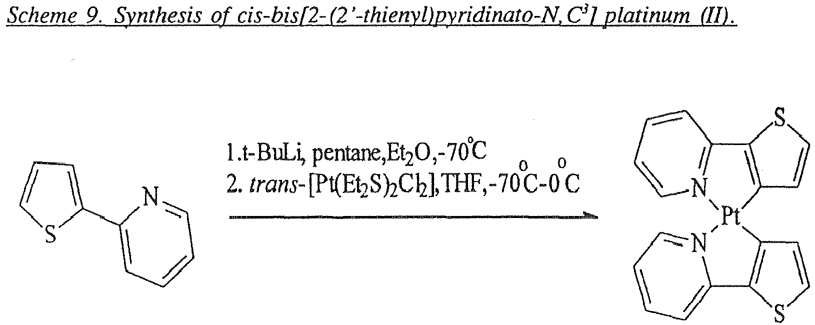 *cis-Bis[2-(2'-thienyl)quinolinato-N,C³) platinum (II).* Was prepared following published procedures (P.Jolliet, M.Gianini, A.von Zelewsky, G.Bernardinelli, H.Stoeckii-Evans, Inorg. Chem. 1996, 35, 4883). (Scheme 10).

Dark red solid (yield 21%).

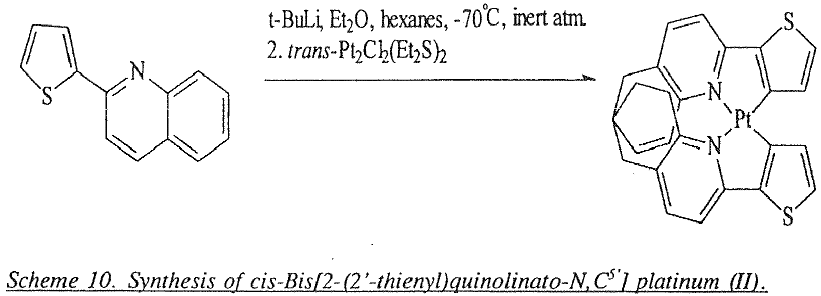

Absorption spectra were recorded on AVIV Model 14DS-UV-Vis-IR spectrophotometer and corrected for background due to solvent absorption. Emission spectra were recorded on PTI QuantaMaster Model C-60SE spectrometer with 1527 PMT detector and corrected for detector sensitivity inhomogeneity.

Vacuum deposition experiments were performed using standard high vacuum system (Kurt J.Lesker vacuum chamber) with vacuum ∼10⁻⁶ torr. Quartz plates (ChemGlass Inc.) or borosilicate glass-IndiumTin Oxide plates (ITO, Delta Technologies,Lmtd.), if used as substrates for deposition, were pre-cleaned according to the published procedure for the later (A.Shoustikov, Y.You, P.E.Burrows, M.E.Thomspon, S.R.Forrest, Synth.Met. 1997, 91, 217).

Thin film spin coating experiments were done with standard spin coater (Specialty Coating Systems, Inc.) with regulatable speed, acceleration speed, and deceleration speed. Most films were spun coat with 4000 RPM speed and maximum acceleration and deceleration for 40 seconds.

### Optical properties of the Pt cyclometalated complexes

Table 1. Absorption and emission properties of several cycloplatinated complexes. Reproduced from A. von Zelewsky et.al (Chem. Phys. Lett., 1985, 122, 375 and Helv. Chim. Acta 1988, 71, 1053). Abbreviation explanations are given in Scheme 1.

| | solvent | absorption | emission spectra | |
|---|---|---|---|---|
| | | λmax(ε) | 77K | 293 K |
| | | | λmax(τ) | λmax(τ) |
| Pt(Phpy)₂ | CH₃CN | 402(12800) | 491(4.0) | - |
| | | 291(27700) | | |
| Pt(Thpy)₂ | CH₃CN | 418(10500) | 570(12.0) | 578(2.2) |
| | | 303(26100) | | |
| Pt(Bhq)₂ | CH₃CN | 421(9200) | 492(6.5) | - |
| | | 367(12500) | | |
| | | 307(15000) | | |
| Pt(bph)(bpy) | | | | |

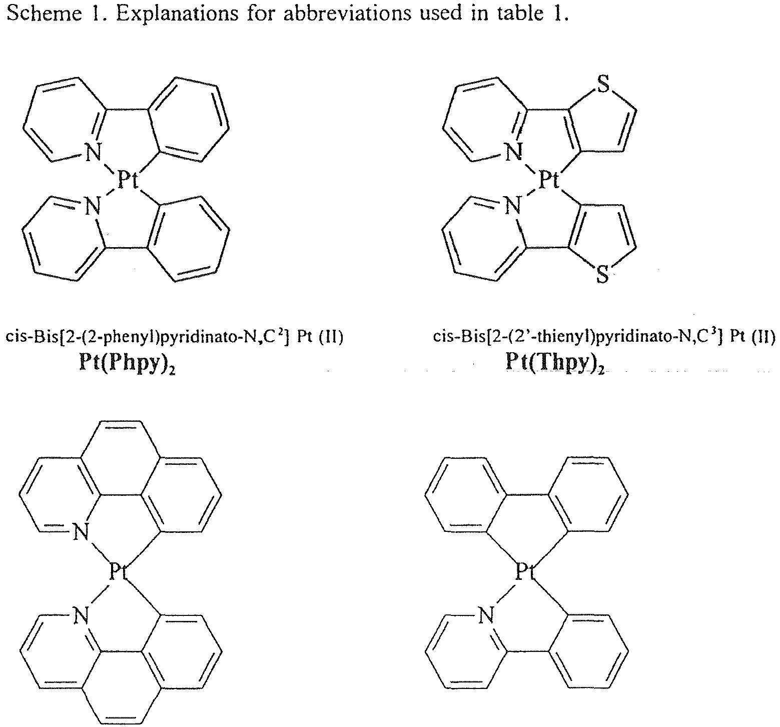

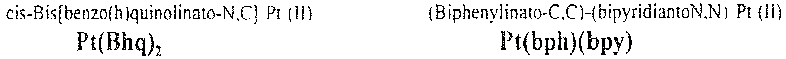

### Optical properties in solution

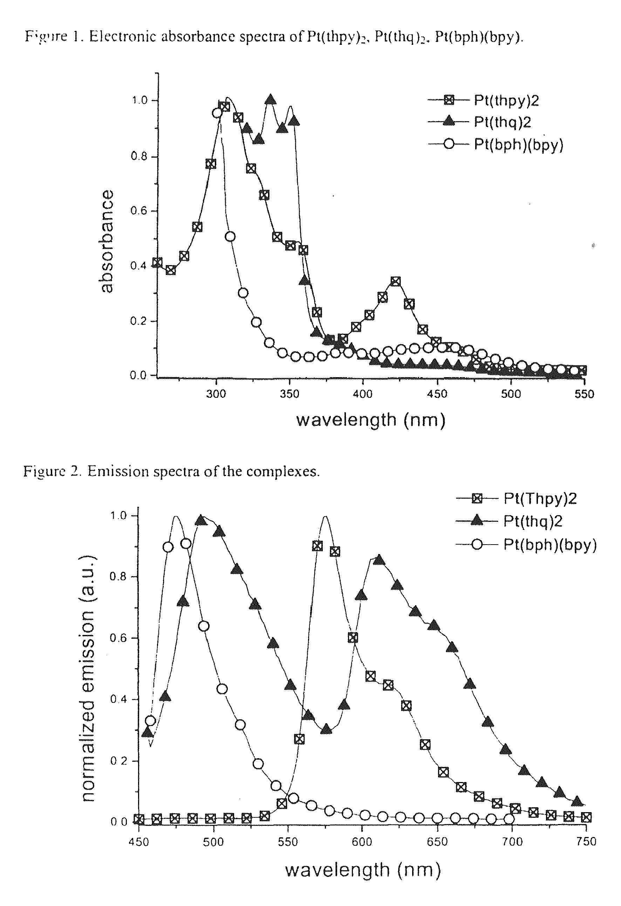

Absorbance spectra of the complexes Pt(thpy)₂, Pt(thq)₂ and Pt(bph)(bpy) in solution (CHCl₃ or CH₂Cl₂) were normalized and are presented in Figure 1. Absorption maximum for Pt(phpy)₂ showed a maximum at ca. 400 nm, but because the complex apparently requires further purification the spectrum is not presented.

Normalized emission spectra are shown in Figure 2. Excitation wavelengths for Pt(thpy)₂, Pt(thq)₂ and Pt(bph)(bpy) are correspondingly 430 nm, 450 nm, and 449 nm (determined by maximum values in their excitation spectra). Pt(thpy)₂ gives strong orange to yellow emission, while Pt(thq)₂ gives two lines at 500 and 620 nm. The emission form these materials is due to efficient phosphorescence. Pt(bph)(bpy) gives blue emission, centered at 470 nm. The emission observed for Pt(bph)(bpy) is most likely due to fluorescence and not phosphorescence.

**Emission lifetimes and quantum yields in solution:**

| | | |
|---|---|---|
| Pt(thPy)₂ | 3.7 µs (CHCl₃, deoxygenated for 10 min) | 0.27 |
| Pt(thq)₂ | 2.6 µs (CHCl₃, deoxygenated for 10 min) | not measured |
| Pt(bph)(bpy) | not in µs region (CH₂0₂, deoxygenated for 10 min) | not measured |

### Optical properties in PS solid matrix

Pt(thpy)₂. Emission maximum is at 580 nm (lifetime 6.5 µs) upon excitation at 400 nm. Based on the increased lifetime for the sample in polystyrene we estimate a quantum efficiency in polystyrene for Pt(thpy)₂ of 0.47.

Pt(thq)2. Emission maximum at 608 nm (lifetime 7.44 µs) upon excitation at 450 nm.

### Optical properties of the complexes in PVK film

These measurements were made for Pt(thpy)₂ only.

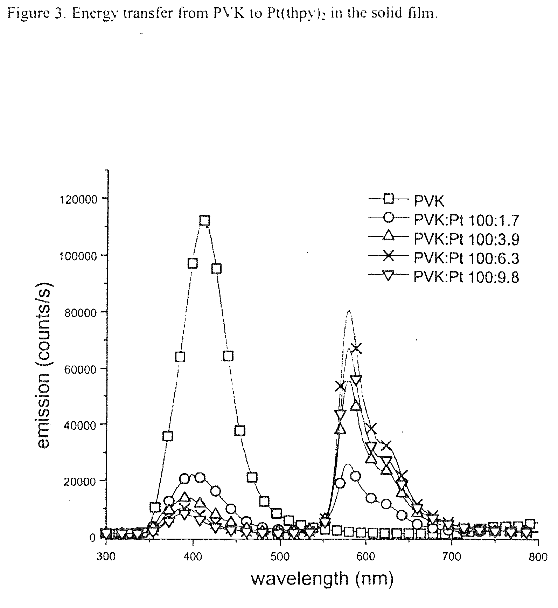

Polyvinylcarbazole (PVK) was excited at 250 nm and energy transfer from PVK to Pt(thpy)₂ was observed (Figure 3). The best weight PVK:Pt(thpy)₂ ratio for the energy transfer was found to be *ca.* 100:6.3.

### Light Emitting Diodes

### ITO/PVK:PBD.Pt(thpy)₂ (100:40:2)/Ag:Mg/Ag

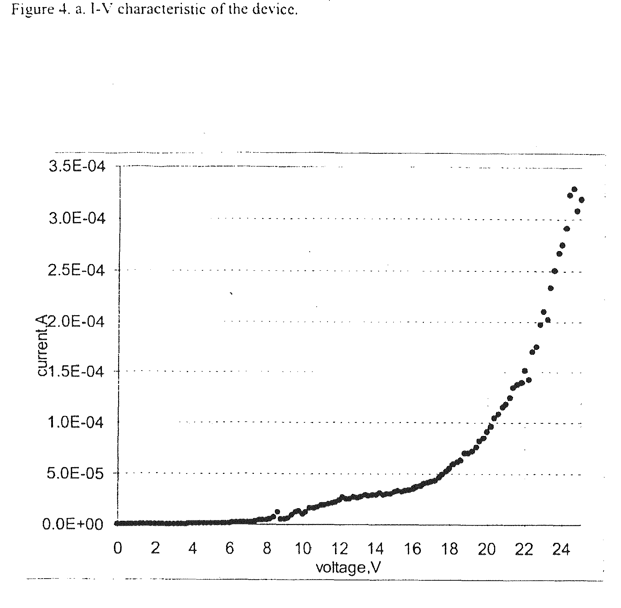

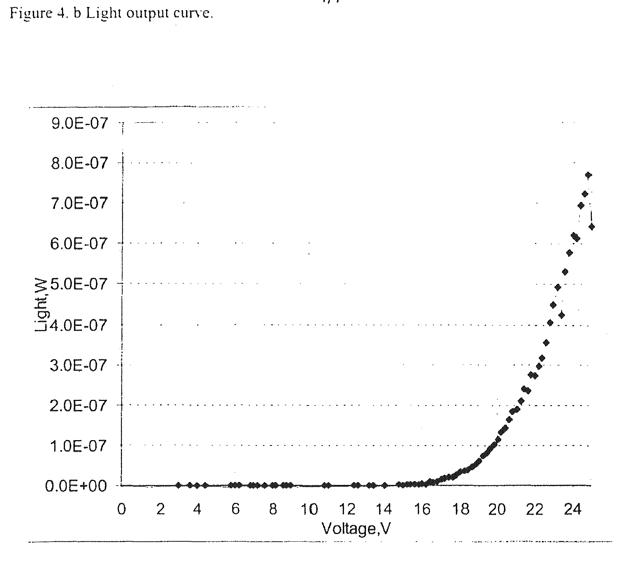

Pt(thpy)₂ does not appear to be stable toward sublimation. In order to test it in an OLED we have fabricated a polymer blended OLED with Pt(thpy)₂ dopant. The optimal doping level was determined by the photoluminescence study described above. The emission form this device comes exclusively from the Pt(thpy)₂ dopant. Typical current-voltage characteristic and light output curve of the device are shown in Figure 4.

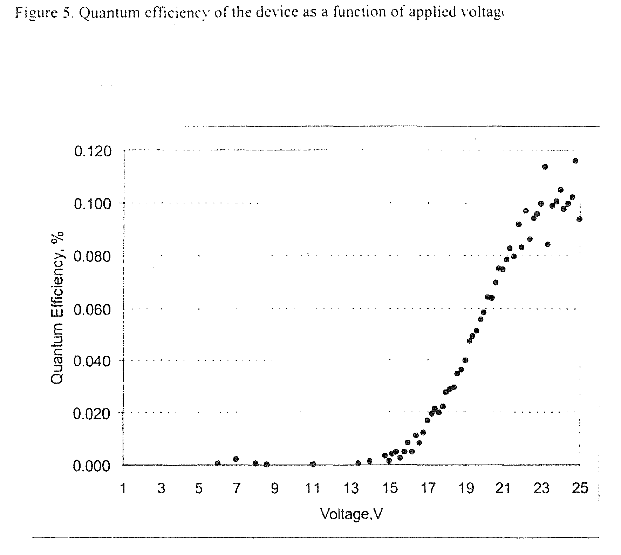

Quantum efficiency dependence on applied voltage is demonstrated in Figure 5.

Thus at 22 V quantum efficiency is ca. 0.11 %. The high voltage required to drive this device is a result of the polymer blend OLED structure and not the dopant. Similar device properties were observed for a polymer blend device made with a coumarin dopant in place of Pt(thpy)₂.

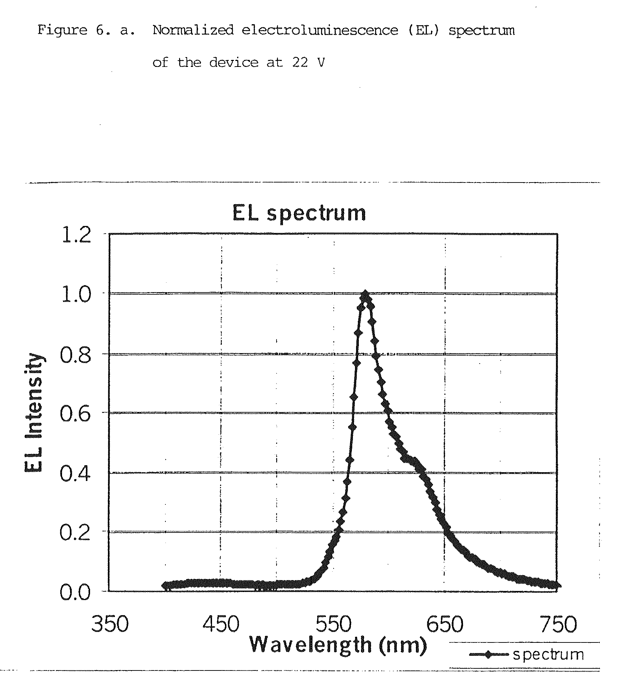

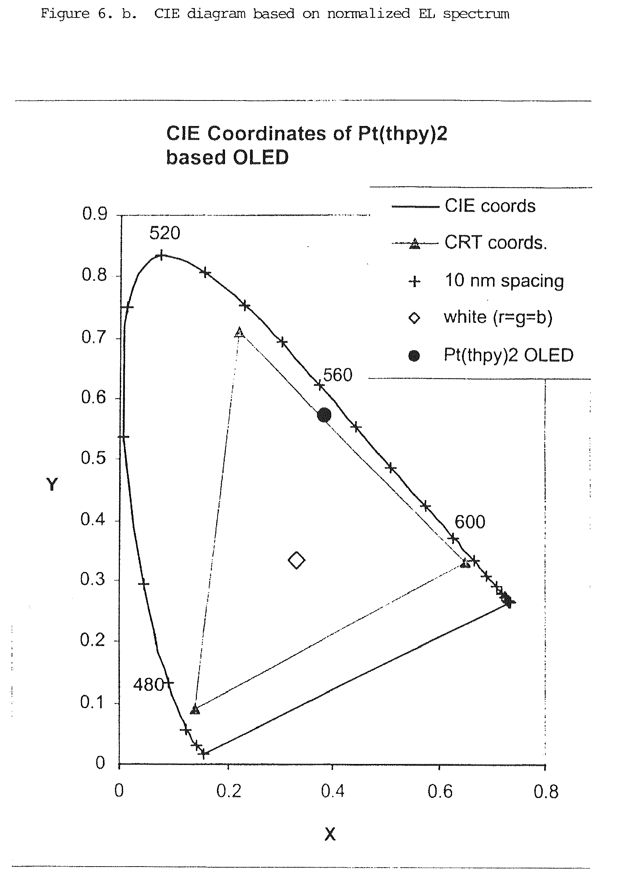

Electroluminescence spectrum and CIE diagram are shown in Figure 6.

Further embodiments are included in the following aspects:
1. In an organic light emitting device comprising a heterostructrue for producing luminescence, an emissive layer, comprising:
   a host material; and
   an emissive molecule, present as a dopant in said host material, adapted to luminescence when a voltage is applied across the heterostructure;
   wherein said emissive molecule is selected from the group consisting of phosphorescent organometallic complexes.
2. The emissive layer of embodiment 1, wherein said emissive molecule is selected from the group consisting of phosphorescent organometallic platinum complexes.
3. The emissive layer of embodiment 1, wherein said emissive molecule is selected from the group consisting of phosphorescent cyclometallated platinum complexes.
4. The emissive layer of embodiment 3, wherein the emission occurs at a wavelength between 400 nm and 700 nm.
5. The emissive layer of embodiment 3, wherein the color of the emission will appear blue.
6. The emissive layer of embodiment 3, wherein the color of the emission will appear green.
7. The emissive layer of embodiment 3, wherein the color of the emission will appear red.
8. The emissive layer of embodiment 3,
   wherein the host material is a hole-transporting matrix and is selected from the group consisting of substituted tri-aryl amines and polyvinylcarbazoles;
9. The emissive layer of embodiment 3,
   wherein the host material is an electron-transporting matrix and is selected from the group consisting of metal quinoxolates, oxidazoles, and triazoles;
10. The emissive layer of embodiment 3, wherein said emissive molecule is selected from the group consisting of Pt(Phpy)₂, Pt(Thpy)₂, and Pt(Bhq)₂.
11. The emissive layer of embodiment 3, wherein the group consisting of Phpy, Thpy and Bhq is substituted with electronic donors and acceptors.
12. In an organic light emitting device comprising a heterostructure for producing luminescence, an emissive layer, comprising:
   a host material;
   an emissive molecule, present as a dopant in said host material, adapted to luminesce when a voltage is applied across the heterostructure;
      wherein said emissive molecule is selected from the group consisting of cyclometallated platinum complexes; and
      a polarization molecule, present as a dopant in said host material and having a dipole moment, that affects the wavelength of light emitting when said emissive dopant molecule luminesces.
13. The emissive layer of the organic light emitting device of embodiment 12, wherein said polarization molecule is selected from the group consisting of aromatic molecules substituted by electronic donors and acceptors.
14. A display incorporating the organic light emitting device of embodiment 1.
15. A computer incorporating the organic light emitting device of embodiment 1.
16. A televison incorporating the organic light emitting device of embodiment 1.
17. A sign incorporating the organic light emitting device of embodiment 1.
18. A method or tuning the wavelength of light emitted by an organic light emitting device, comprising the steps of:
   selecting a host material; and
   selecting an emissive molecule, present as a dopant in said host material, adapted to luminesce when a voltage is applied across the heterostructure;
   wherein said emissive molecule is selected from the group consisting of cyclometallated platinum complexes.

## Claims

1. The use of a phosphorescent organometallic platinum complex as an emissive molecule in an organic light emitting device comprising a heterostructure for producing luminescence when a voltage is applied across the heterostructure.

2. A use according to claim 1, wherein the organic light emitting device comprising a heterostructure comprises an emissive layer, the emissive layer comprising a host material and said emissive molecule, present as a dopant in said host material, adapted to luminesce when a voltage is applied across the heterostructure.

3. A use according to claim 1 or 2, wherein said emissive molecule is selected from the group consisting of phosphorescent cyclometallated platinum complexes.

4. A use according to claim 3, wherein the emission occurs at a wavelength between 400 nm and 700 nm.

5. A use according to claim 3, wherein the color of the emission will appear blue.

6. A use according to claim 3, wherein the color of the emission will appear green.

7. A use according to claim 3, wherein the color of the emission will appear red.

8. A use according to claim 3, wherein the host material is a hole-transporting matrix and is selected from the group consisting of substituted tri-aryl amines and polyvinylcarbazoles.

9. A use according to claim 3, wherein the host material is an electron-transporting matrix and is selected from the group consisting of metal quinoxolates and triazoles.

10. A use according to claim 3, wherein said emissive molecule is selected from the group consisting of Pt(Phpy)₂, Pt(Thpy)₂, and Pt(Bhq)₂ (cis-Bis[2-(2-phenyl)pyridinato-N,C²] Pt(II), cis-Bis[2-(2'-thienyl)pyridinato-N,C³] Pt(II), cis-Bis[benzo(h)quinolinato-N,C] Pt(II)).

11. A use according to claim 3, wherein said emissive molecule contains Phpy (2-phenylpyridine), Thpy (2-(2'-thienyl)pyridine) and Bhq (benzo(h)quinoline) which contain substituents selected from electronic donors and acceptors.

12. A use according to claim 1 or 2, wherein said emissive molecule is selected from the group consisting of cyclometallated platinum complexes, and comprising a polarization molecule, present as a dopant in said host material and having a dipole moment, that affects the wavelength of light emitted when said emissive dopant molecule luminesces.

13. A use according to claim 12, wherein said polarization molecule is selected from the group consisting of aromatic molecules substituted by electronic donors and acceptors.

14. A use according to any one of the previous claims, wherein the organic light emitting device is incorporated in a display, computer, television or sign.
